# EUROPEAN PATENT APPLICATION

(11) **EP 1 918 775 A2**
(43) Date of publication of application: **07.05.2008**
(21) Application number: 07020637.0
(22) Date of filing: 22.10.2007
(51) Int. Cl.: G03F 1/08

(54) **Mask etch process**

(30) Priority: 30.10.2006 US 863474 P
(71) Applicant: Applied Materials, Inc., Santa Clara, CA 95054 (US)
(72) Inventor: Chandrachood, Madhavi, R., Sunnyvale CA 94086 (US); Sabharwal, Amitabh, San Jose CA 95120 (US); Leung, Toi, Yue, Becky, Sunnyvale CA 94087 (US); Grimbergen, Michael, Redwood City CA 94065 (US)
(74) Representative: Zimmermann, Gerd Heinrich

(57) **Abstract**

Method and apparatus for etching a metal layer disposed on a substrate, such as a photolithographic reticle, are provided. In one aspect, a method is provided for processing a substrate including positioning a substrate (122) having a metal photomask layer (320) disposed on a optically transparent material in a processing chamber, introducing a processing gas processing gas comprising an oxygen containing gas, a chlorine containing gas, at least one of trifluoromethane (CHF₃), sulfur hexafluoride (SF₆), hexafluoroethane (C₂F₆) or ammonia (NH₃) and optionally a chlorine-free halogen containing gas and/or an inert gas, into the processing chamber, generating a plasma of the processing gas in the processing chamber, and etching exposed portions of the metal layer disposed on the substrate.

## Description

The present invention relates to the fabrication of integrated circuits and to the fabrication of photolithographic reticles useful in the manufacture of integrated circuits.

Semiconductor device geometries have dramatically decreased in size since such devices were first introduced several decades ago. Since then, integrated circuits have generally followed the two year/half-size rule (often called Moore's Law), which means that the number of devices on a chip doubles every two years. Today's fabrication plants are routinely producing devices having 0.15 µm and even 0.13 µm feature sizes, and tomorrow's plants soon will be producing devices having even smaller geometries.

The increasing circuit densities have placed additional demands on processes used to fabricate semiconductor devices. For example, as circuit densities increase, the widths of vias, contacts and other features, as well as the dielectric materials between them, decrease to sub-micron dimensions, whereas the thickness of the dielectric layers remains substantially constant, with the result that the aspect ratios for the features, *i.e.,* their height divided by width, increases. Reliable formation of high aspect ratio features is important to the success of sub-micron technology and to the continued effort to increase circuit density and quality of individual substrates.

High aspect ratio features are conventionally formed by patterning a surface of a substrate to define the dimensions of the features and then etching the substrate to remove material and define the features. To form high aspect ratio features with a desired ratio of height to width, the dimensions of the features are required to be formed within certain parameters that are typically defined as the critical dimensions of the features. Consequently, reliable formation of high aspect ratio features with desired critical dimensions requires precise patterning and subsequent etching of the substrate.

Photolithography is a technique used to form precise patterns on the substrate surface, and then the patterned substrate surface is etched to form the desired device or features. Photolithography techniques use light patterns and resist materials deposited on a substrate surface to develop precise patterns on the substrate surface prior to the etching process. In conventional photolithographic processes, a resist is applied on the layer to be etched, and the features to be etched in the layer, such as contacts, vias, or interconnects, are defined by exposing the resist to a pattern of light through a photolithographic reticle having a photomask layer disposed thereon. The photomask layer corresponds to the desired configuration of features. A light source emitting ultraviolet (UV) light or low X-ray light, for example, may be used to expose the resist in order to alter the composition of the resist. Generally, the exposed resist material is removed by a chemical process to expose the underlying substrate material. The exposed underlying substrate material is then etched to form the features in the substrate surface while the retained resist material remains as a protective coating for the unexposed underlying substrate material.

Binary photolithographic reticles typically include a substrate made of an optically transparent silicon-based material, such as quartz (*i.e.,* silicon dioxide, SiO₂), having an opaque light-shielding layer of metal, or photomask, typically chromium, disposed on the surface of the substrate. The light-shielding layer is patterned to correspond to the features to be transferred to the substrate. Binary photolithographic reticles are fabricated by first depositing a thin metal layer on a substrate comprising an optically transparent silicon-based material, and then depositing a resist layer on the thin metal layer. The resist is then patterned using conventional laser or electron beam patterning equipment to define the critical dimensions to be transferred to the metal layer. The metal layer is then etched to remove the metal material not protected by the patterned resist; thereby exposing the underlying optically transparent material and forming a patterned photomask layer. Photomask layers allow light to pass therethrough in a precise pattern onto the substrate surface.

Conventional etching processes, such as wet etching, tend to etch isotropically, which can result in an undercut phenomenon in the metal layer below the patterned resist. The undercut phenomenon can produce patterned features on the photomask that are not uniformly spaced and do not have desired straight, vertical sidewalls, thereby losing the critical dimensions of the features. Additionally, the isotropic etching of the features may overetch the sidewalls of features in high aspect ratios, resulting in the loss of the critical dimensions of the features. Features formed without the desired critical dimensions in the metal layer can detrimentally affect light passing therethrough and result in less than desirable patterning by the photomask in subsequent photolithographic processes.

Plasma etch processing, known as dry etch processing or dry etching, provides a more anisotropic etch than wet etching processes. The dry etching process has been shown to produce less undercutting and to improve the retention of the critical dimensions of the photomask features with straighter sidewalls and flatter bottoms. However, dry etching may overetch or imprecisely etch the sidewalls of the openings or pattern formed in the resist material used to define the critical dimensions of the metal layer. Excess side removal of the resist material results in a loss of the critical dimensions of the patterned resist features, which may translate to a loss of critical dimensions of the features formed in the metal layer defined by the patterned resist layer. Further, imprecise etching may not sufficiently etch the features to provide the necessary critical dimensions. Failure to sufficiently etch the features to the critical dimensions is referred to as a "gain" of critical dimensions. The degree of loss or gain of the critical dimensions in the metal layer is referred to as "etching bias" or "CD bias". The etching bias can be as large as 120 nm in photomask patterns used to form 0.14 µm features on substrate surfaces.

The loss or gain of critical dimensions of the pattern formed in the metal layer can detrimentally affect the light passing therethrough and produce numerous patterning defects and subsequent etching defects in the substrate patterned by the photolithographic reticle. The loss or gain of critical dimensions of the photomask can result in insufficient photolithographic performance for etching high aspect ratios of sub-micron features and, if the loss or gain of critical dimensions is severe enough, the failure of the photolithographic reticle or subsequently etched device.

Therefore, there remains a need for a process and chemistry for etching a metal layer on a substrate, such as a reticle, to produce a pattern with desired critical dimensions in the metal layer.

In light of the above, methods for processing a photolithographic reticle according to independent claims 1 and 16 are provided.
Further advantages, features, aspects and details of the invention are evident from the dependent claims, the description and the drawings.
Aspects of the invention generally provide methods and related chemistry for etching a photomask layer for a photolithographic reticle. In one aspect, a method is provided for processing a photolithographic reticle in a processing chamber. The reticle comprises a metal photomask layer formed on an optically transparent substrate and a patterned resist material deposited on the metal photomask layer. The reticle is processed by introducing a processing gas comprising an oxygen containing gas, a chlorine containing gas, at least one of trifluoromethane (CHF₃), sulfur hexafluoride (SF₆), hexafluoroethane (C₂F₆) or ammonia (NH₃), and optionally a chlorine-free halogen containing gas and/or an inert gas. Power is delivered to the processing chamber to FORM a plasma FROM the processing gas. Exposed portions of the metal photomask layer are subsequently etched using the plasma.

In another aspect, a method is provided for processing a photolithographic reticle on a support member in a processing chamber. The reticle comprises a chromium-based photomask layer formed on an optically transparent silicon-based material and a patterned resist material deposited on the chromium-based photomask layer. The reticle is processed by introducing a processing gas comprising chlorine gas, oxygen gas, at least one of CHF₃, SF₆, C₂F₆ or NH₃ and optionally hydrogen bromide at a chamber pressure between about 1 milliTorr and about 40 milliTorr. A source power of between about 200 and about 1500 watts is delivered to a coil disposed proximate the processing chamber to generate a plasma from the process gas. A bias power between about 5 and about 200 watts is supplied to the support member. Exposed portions of the chromium-based photomask layer are subsequently etched using the plasma at a removal rate ratio of chromium-based photomask layer to resist material of about 1:1 or greater.
Embodiments are also directed to apparatuses provided by the disclosed methods and including apparatus parts corresponding to described method steps. Furthermore, embodiments are also directed to methods by which the described apparatus is manufactured. It may include method steps for manufacturing parts of the apparatus. The method steps may be performed by way of hardware components, firmware, software, a computer programmed by appropriate software, by any combination thereof or in any other manner.

So that the manner in which the above recited aspects of the invention are attained and can be understood in detail, a more particular description of the invention, briefly summarized above, may be had by reference to the embodiments thereof which are illustrated in the appended drawings.

It is to be noted, however, that the appended drawings illustrate only typical embodiments of this invention and are therefore not to be considered limiting of its scope, for the invention may admit to other equally effective embodiments.

Figure 1 is a schematic cross-sectional view of one embodiment of an etching chamber;

Figure 2 is a flow chart illustrating one embodiment of a sequence for processing a substrate according to one embodiment of the invention;

Figures 3A-3D are cross-sectional views showing an etching sequence of another embodiment of the invention.

To facilitate understanding, identical reference numerals have been used, wherever possible, to designate identical elements that are common to the figures. It is contemplated that features of one embodiment may be beneficially incorporated in other embodiments without further recitation.

Aspects of the invention will be described below in reference to an inductively coupled plasma etch chamber. Suitable inductively coupled plasma etch chambers include the ETEC Tetra I™ photomask etch chamber and the ETEC Tetra II™ photomask etch chamber, available from ETEC of Hayward, California, or optionally, a Decoupled Plasma Source (DPS I™, DPS II™, and DPS Plus™) processing chamber available from Applied Materials, Inc., of Santa Clara, California.

Other process chambers may be used to perform the processes of the invention, including, for example, capacitively coupled parallel plate chambers and magnetically enhanced ion etch chambers as well as inductively coupled plasma etch chambers of different designs. Examples of such suitable processing chambers are disclosed in U.S, Patent Application Serial No. 09/325,026, filed on June 3, 1999. Although the processes are advantageously performed with the ETEC Tetra™ photomask etch chamber, the description of the processing chamber is illustrative, and should not be construed or interpreted to limit the scope of any aspect of the invention. It is also contemplated that the invention may be beneficially practiced in other processing chambers, including those from other manufacturers.

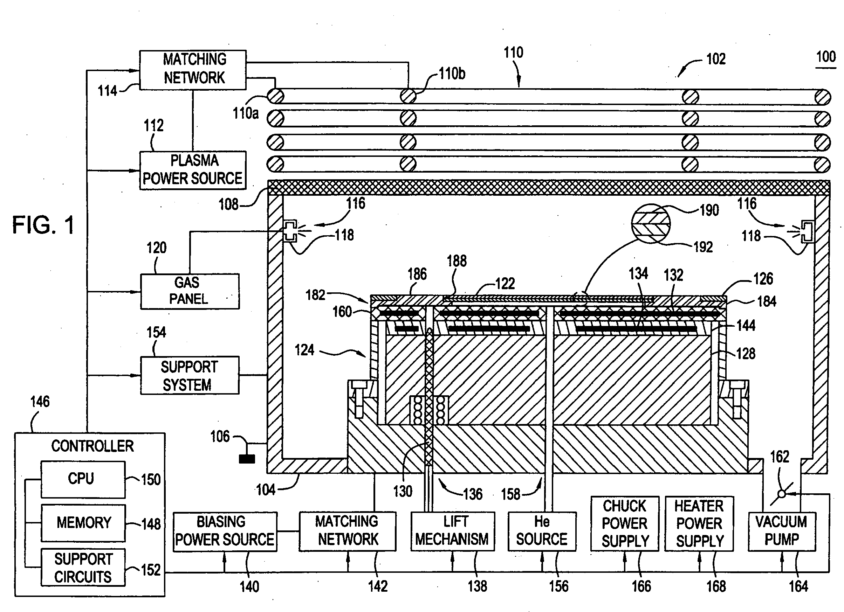

Figure 1 is a schematic cross-sectional view of one embodiment of a processing chamber 100 generally comprising a process chamber body 102 having a substrate pedestal 124, and a controller 146. The chamber body 102 has a conductive wall 104 that supports a substantially flat dielectric ceiling 108. Other embodiments of the processing chamber 100 may have other types of ceilings, e.g., a dome-shaped ceiling. An antenna 110 is disposed above the ceiling 108. The antenna 110 comprises one or more inductive coil elements that may be selectively controlled (two co-axial elements 110a and 110b are shown in Figure 1). The antenna 110 is coupled through a first matching network 114 to a plasma power source 112. The plasma power source 112 is typically capable of producing up to about 3000 Watts (W) at a tunable frequency in a range from about 50 kHz to about 13.56 MHz.

The substrate pedestal (cathode) 124 is coupled through a second matching network 142 to a biasing power source 140. The biasing source 140 provides between about zero to about 600 W at a tunable pulse frequency in the range of about 1 to about 10 kHz. The biasing source 140 produces pulsed RF power output. Alternatively, the biasing source 140 may produce pulsed DC power output. It is contemplated that the source 140 may also provide a constant DC and/or RF power output.

In one embodiment, the substrate support pedestal 124 includes an electrostatic chuck 160. The electrostatic chuck 160 comprises at least one clamping electrode 132 and is controlled by a chuck power supply 166. In alternative embodiments, the substrate pedestal 124 may comprise substrate retention mechanisms such as a susceptor clamp ring, a vacuum chuck, a mechanical chuck, and the like.

A gas panel 120 is coupled to the processing chamber 100 to provide process and/or other gases to the interior of the process chamber body 102. In the embodiment depicted in Figure 1, the gas panel 120 is coupled to one or more inlets 116 formed in a channel 118 in the sidewall 104 of the chamber body 102. It is contemplated that the one or more inlets 116 may be provided in other locations, for example, in the ceiling 108 of the processing chamber 100.

The pressure in the processing chamber 100 is controlled using a throttle valve 162 and a vacuum pump 164. The vacuum pump 164 and throttle valve 162 are capable of maintaining chamber pressures in the range of about 1 to about 20 mTorr.

The temperature of the wall 104 may be controlled using liquid-containing conduits (not shown) that run through the wall 104. Wall temperature is generally maintained at about 65 degrees Celsius. Typically, the chamber wall 104 is formed from a metal (e.g., aluminum, stainless steel, and the like) and is coupled to an electrical ground 106. The processing chamber 100 also comprises conventional systems for process control, internal diagnostic, end point detection, and the like. Such systems are collectively shown as support systems 154.

A reticle adapter 182 is used to secure a substrate (such as a reticle or other workpiece) 122 onto the substrate support pedestal 124. The reticle adapter 182 generally includes a lower portion 184 milled to cover an upper surface of the pedestal 124 (for example, the electrostatic chuck 160) and a top portion 186 having an opening 188 that is sized and shaped to hold the substrate 122. The opening 188 is generally substantially centered with respect to the pedestal 124. The adapter 182 is generally formed from a single piece of etch resistant, high temperature resistant material such as polyimide ceramic or quartz. A suitable reticle adapter is disclosed in United States Patent No. 6,251,217, issued on June 26, 2001. An edge ring 126 may cover and/or secure the adapter 182 to the pedestal 124.

A lift mechanism 138 is used to lower or raise the adapter 182, and hence, the substrate 122, onto or off of the substrate support pedestal 124. Generally, the lift mechanism 138 comprises a plurality of lift pins (one lift pin 130 is shown) that travel through respective guide holes 136.

In operation, the temperature of the substrate 122 is controlled by stabilizing the temperature of the substrate pedestal 124. In one embodiment, the substrate support pedestal 124 comprises a heater 144 and an optional heat sink 128. The heater 144 may be one or more fluid conduits configured to flow a heat transfer fluid therethrough. In another embodiment, the heater 144 may include at least one heating element 134 that is regulated by a heater power supply 168. Optionally, a backside gas (e.g., helium (He)) from a gas source 156 is provided via a gas conduit 158 to channels that are formed in the pedestal surface under the substrate 122. The backside gas is used to facilitate heat transfer between the pedestal 124 and the substrate 122. During processing, the pedestal 124 may be heated by the embedded heater 144 to a steady-state temperature, which in combination with the helium backside gas, facilitates uniform heating of the substrate 122.

The controller 146 comprises a central processing unit (CPU) 150, a memory 148, and support circuits 152 for the CPU 150 and facilitates control of the components of the processing chamber 100 and, as such, of the etch process, as discussed below in further detail. The controller 146 may be one of any form of general-purpose computer processor that can be used in an industrial setting for controlling various chambers and sub-processors. The memory 148 of the CPU 150 may be one or more of readily available memory such as random access memory (RAM), read only memory (ROM), floppy disk, hard disk, or any other form of digital storage, local or remote. The support circuits 152 are coupled to the CPU 150 for supporting the processor in a conventional manner. These circuits include cache, power supplies, clock circuits, input/output circuitry and subsystems, and the like. The inventive method is generally stored in the memory 148 or other computer-readable medium accessible to the CPU 150 as a software routine. Alternatively, such software routine may also be stored and/or executed by a second CPU (not shown) that is remotely located from the hardware being controlled by the CPU 150.

While the following process description illustrates one embodiment of etching a substrate using processing gases as described herein, the invention contemplates the use of processing parameters outside the ranges described herein for performing this process in different apparatus, such as a different etching chamber, and for different substrate sizes, such as photolithographic reticles for 300 mm substrate processing.

### Exemplary Etch Process

While the following description illustrates one embodiment of a process sequence for etching metal layers, such as chromium and chromium oxynitride, as photomasks in photolithographic reticle fabrication, it is contemplated that the etching gases may be used to etch other material layers formed on substrates in semiconductor and photolithographic reticle manufacturing.

Generally a photolithographic reticle includes an opaque layer, known as a photomask, deposited on an optically transparent substrate. The opaque layer may comprise a metal layer, for example, chromium, or another material known or unknown in the art suitable for use as a photomask. For example, the invention contemplates that the opaque layer may comprise a non-metallic dielectric material. An optically transparent material of the substrate 122 is broadly defined to include, but not limited to, a material transparent to light having wavelengths of about 300 nanometers (nm) or less, for example, transparent to ultraviolet light having wavelengths of 248 nm and 193 nm.

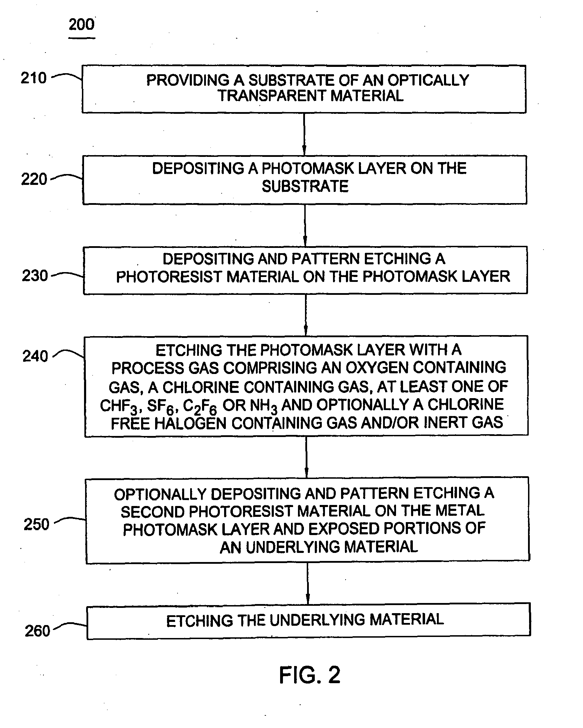

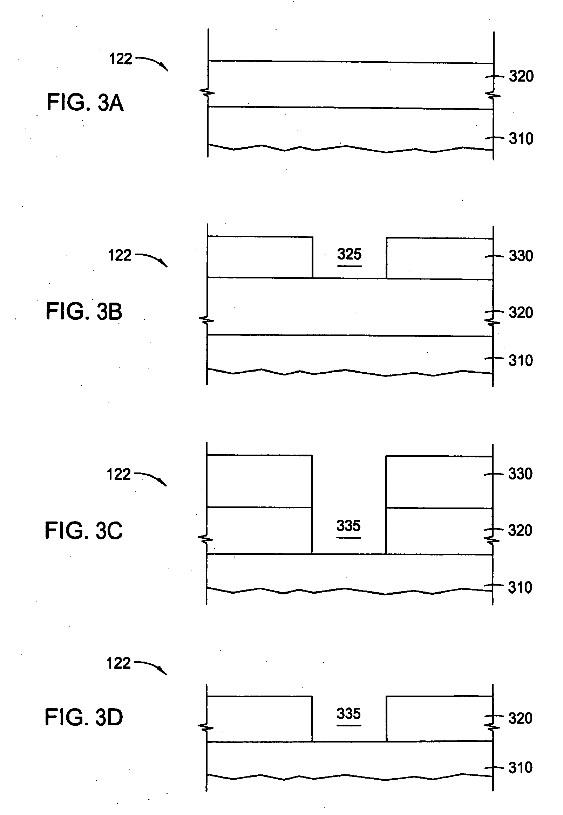

Figure 2 is a flow chart of one embodiment of one process sequence of an etching process 200. The flow chart is provided for illustrative purposes and should not be construed as limiting the scope of any aspects of the invention. Figures 3A-3C illustrate the composition of the photolithographic reticle at points during the photomask forming process as well as further illustrate the process described above in Figure 2.

The substrate 122, typically comprising an optically transparent material 310, such as optical quality quartz, fused silica material, molybdenum silicide (MoSi), molybdenum silicon oxynitride (MoSi_{X}N_{Y}O_{Z}), calcium fluoride, alumina, sapphire, or combinations thereof, is provided to a processing chamber at step 210, such as the processing chamber 100 of Figure 1.

The substrate 122 is then processed by depositing an opaque metal layer 320 as a metal photomask layer, typically comprising chromium, on the substrate material 310 at step 220 as shown in Figure 3A. The chromium layer may be deposited by conventional methods known in the art, such as by physical vapor deposition (PVD) or chemical vapor deposition (CVD) techniques. The metal layer 320 is typically deposited to a thickness between about 50 and about 100 nm; however, the thickness of the metal layer 320 may differ based upon the requirements of the manufacturer and the composition of the materials of the substrate or metal layer.

Optionally, an anti-reflective coating (ARC or ARC layer) may be formed on or comprise part of the deposited metal layer 320. The ARC layer is believed to improve photolithographic precision in patterning features to be formed in the opaque layer. The ARC layer may be a metal layer incorporating nonmetallic contaminants or impurities to form, for example a metal oxynitride layer, such as chromium oxynitride. Chromium oxynitride may be formed during deposition of the metal layer or by exposing the metal layer to a suitable atmosphere, such as an oxidizing and nitrating environment. Alternatively, the chromium oxynitride layer may be deposited by conventional methods known in the art, such as by physical vapor deposition (PVD) or chemical vapor deposition (CVD) techniques. The metal oxynitride layer may comprise up to the top 25 percent of the total thickness of the metal layer 320.

The optional ARC layer is typically formed at a thickness between about 10 nm and about 15 nm; however, the thickness of the layer may differ based upon the requirements of the manufacturer and the composition of the materials of the substrate or metal layer, and may be mainly concentrated in the upper surface of the deposited material, such as the upper 30 percent of the thickness of the original metal layer 320. The chromium oxynitride film is believed to be more sensitive to etching with oxygen radicals than chromium films. A reduced amount of oxygen in the processing gas may be used to effectively etch the chromium oxynitride surface compared to etching the bulk of the remaining chromium material.

The dimensions of openings or patterns in the metal layer 320 are patterned by depositing and pattern etching a resist material 330 to expose the metal layer 320 at step 230 as shown in Figure 3B. The resist materials used in photolithographic reticle fabrication are usually low temperature resist materials, which are defined herein as materials that thermally degrade at temperatures above about 250 degrees Celsius (°C), an example of which includes "ZEP," manufactured by Hoya Corporation or others described herein. The resist material 330 is deposited upon the metal layer 320 to a thickness between about 200 nm and about 600 nm.

The resist material may be a photoresist material, which may be patterned optically using a laser patterning device or by another radiative energy patterning device, such as an electron beam emitter to form a pattern 325 that is used to define the dimensions of the feature definition to be formed in the metal layer 320.

The opaque, metal layer then is etched to produce a photomask layer having features with desired critical dimensions. The substrate 122 is then transferred to an etch chamber, such as the processing chamber 100 described above, for etching the metal layer 320. Openings and patterns 335 are formed in the metal layer 320 by etching the metal layer to expose the underlying optically transparent substrate material, and optionally, an ARC layer, at step 240 as shown in Figure 3C.

Etching of exposed portions of the opaque metal layer 320 occurs by generating a plasma of a processing gas by supplying a source power and/or a bias power to the processing chamber 100. The processing gas may be used for etching the metal layer and may include an oxygen containing gas, a chlorine containing gas, and at least one of trifluoromethane (CHF₃), sulfur hexaflouride (SF₆), hexafluoroethane (C₂F₆) or ammonia (NH₃).

The oxygen containing gas is selected from the group comprising one or more of oxygen (O₂), carbon monoxide (CO), carbon dioxide (CO₂), and combinations thereof. In one embodiment, the oxygen containing gas is oxygen is oxygen. The oxygen containing gas provides a source of etching radicals. Carbon monoxide (CO) and carbon dioxide (CO₂) gases, when selected, may provide a source of material for forming passivating polymer deposits, which may improve etch bias.

The chlorine containing gas is selected from the group comprising one or more of chlorine gas (Cl₂), carbon tetrachloride (CCl₄), hydrogen chloride (HCl), and combinations thereof. In one embodiment, the chlorine containing gas is Cl₂. The chlorine containing gas is used to supply highly reactive radicals to etch the metal layer. The chlorine containing gas provides a source of etching radicals and components, such as carbon tetrachloride (CCl₄) gas, that may provide a source of material for forming passivating polymer deposits, which may improve etch bias. Other gases such as trifluoromethane (CHF₃), sulfur hexafluoride (SF₆), hexafluoroethane (C₂F₆) and ammonia (NH₃) may be selected to increase the etch selectivity of chromium to photoresist, and reduce etch bias.

Optionally, a chlorine-free halogen containing gas may be included. The chlorine-free halogen containing gas may be selected from the group comprising one or more of hydrogen bromide (HBr), hydrogen iodide (HI), and combinations thereof. In one embodiment, the chlorine-free halogen containing gas is HBr. Hydrogen bromide may also be delivered to processing from an aqueous solution or have an aqueous component as hydrobromic acid. The chlorine-free halogen containing gas may be used to supply both reactive radicals to etch the metal layer as well as hydrogen, which may reduce photoresist and metal etch rates and passivate the photoresist and metal sidewalls to minimize overetching and preserve desired critical dimensions, and improve etch bias.

The chlorine containing gas and the chlorine-free halogen containing gas, if provided, are provided in a molar ratio of chlorine containing gas to the chlorine-free halogen containing gas between about 10:1 and about 0.5:1, for example, a chlorine to hydrogen bromide molar ratio between about 10:1 and about 0.5:1.

The processing gas may also include an inert gas which, when ionized as part of the plasma including the processing gas, results in sputtering species to increase the etching rate of the features. The presence of an inert gas as part of the plasma may also enhance dissociation of the active processing gases. Consequently, the inert gas helps to control the radial etch rate. The etch rate may be controlled to be center fast or center slow. Examples of inert gases include argon (Ar), helium (He), neon (Ne), xenon (Xe), krypton (Kr), and combinations thereof, of which argon and helium are generally used. The inert gases typically comprise between about 5 vol percent and about 40 vol percent, such as between about 15 vol percent and about 25 vol percent of the total gas flow for the process. For plasma striking to initiate the plasma prior to introducing the etching processing gas, the inert gas may comprise between about 75 vol percent and about 100 vol percent of the process gas used.

The total flow rate of the processing gas, including the inert gas, is introduced at a flow rate between about 100 sccm and about 700 sccm for etching a 150 mm by 150 mm square photolithographic reticles in an etch chamber. The oxygen containing gas may be introduced into the processing chamber 100 at a flow rate between about 5 sccm and about 200 sccm, for example, about 20-50 sccm. The chlorine containing gas may be introduced into the processing chamber 100 at a flow rate of between about 25 sccm and about 1000 sccm, for example, about 150-300 sccm. At least one of CHF₃, SF₆, C₂F₆ or NH₃, optionally along with the chlorine-free halogen containing gas, may be introduced into the processing chamber 100 at a flow rate of between about 1 sccm and about 50 sccm, for example, between about 1-5 sccm. When the inert gas is utilized, a flow rate between about 5 sccm and about 100 sccm, for example 20-45 sccm, may be provided.

The individual and total gas flows of the processing gases may vary based upon a number of processing factors, such as the size of the processing chamber 100, the size of the substrate 122 being processed, and the specific etching profile desired by the operator.

Generally, a source RF power level of about 15000 W or less is applied to an inductor coil to generate and sustain a plasma of the processing gases during the etching process. A power level between about 200 W and about 1500 W, such between about 300-350 W, has been observed to provide sufficient plasma of the processing gases for etching the substrate surface. The recited source RF power levels have been observed to produce sufficient etching radicals and polymerization radicals from the processing gases to etch the exposed metal layer disposed on the substrate while providing a sufficiently low power level, compared to prior art metal etch processes, for the substrate temperatures to be about 150 °C or less.

Generally, a bias power of less than about 200 Watt is applied to the substrate 122 to increase directionality of the etching radicals with respect to the surface of the substrate 122. A bias power of less than 50 W may be used in the etching process. A bias between about 15 W and 20 W has been observed to provide sufficient directionality of etching radicals during the etching process.

The exposed material of the substrate surface may be etched by the plasma of the processing gases for between about 15 seconds and about 400 seconds, for example, between about 30 seconds and about 350 seconds, depending on the quantity of material to be etched. Any ARC layer material may be exposed to the plasma of the first processing gas for between about 5 seconds and about 180 seconds, for example between about 30 seconds and about 60 seconds, which may in addition to or inclusive of the total etching time.

Generally, the processing chamber pressure is maintained between about 1 milliTorr and about 40 milliTorr, preferably between about 3 milliTorr and about 8 milliTorr, may be maintained during the etching process.

The substrate 122 is also maintained at a temperature of about 150 °C or less during processing. A substrate temperature below about 150 °C or less has minimal heat degradation of materials, such as resist materials, deposited on the substrate during the photolithographic reticle fabrication processes with the processing gases described herein. The substrate temperature between about 20 °C and about 150 °C, for example between about 20 °C and about 50 °C, may be used to etch photomask features with minimal heat degradation of material disposed on the substrate surface. Additionally, the sidewalls 104 of the processing chamber 100 may be maintained at a temperature of less than about 70 °C and the dome is preferably maintained at a temperature of less than about 80 degrees Celsius to maintain consistent processing conditions and to minimize polymer formation on the surfaces of the processing chamber.

An example of the etching process is described as follows. The substrate 122 is disposed on the support member 124 and a processing gas as described herein is introduced into the chamber 100 and a plasma is generated or maintained to etch the metal layer 320 by introducing a processing gas of oxygen gas (O₂), chlorine gas (Cl₂), an additional gas of at least one of trifluoromethane (CHF₃), sulfur hexafluoride (SF₆), hexafluoroethane (C₂F₆) or ammonia (NH₃) and optionally hydrogen bromide (HBr) and/or an inert gas, such as argon (Ar) or helium (He) at a flow rate between about 100 sccm and about 200 sccm and generating a plasma from the processing gas. Oxygen gas may be introduced into the processing chamber 100 at a flow rate between about 5 sccm and about 200 sccm, chlorine gas may be introduced into the processing chamber 100 at a flow rate between about 25 sccm and about 1000 sccm, the additional gas of at least one of trifluoromethane (CHF₃), sulfur hexafluoride (SF₆), hexafluoroethane (C₂F₆) or ammonia (NH₃) and optionally hydrogen bromide (HBr) gas may be introduced into the processing chamber 100 at a flow rate between about 1 sccm and about 50 sccm. The inert gas, for example, argon, is introduced into the processing chamber 100 at a flow rate between about 5 sccm and about 100 sccm. The ratio of chlorine gas to hydrogen bromide, if provided, in the processing gas is between about 10:1 and about 0.5:1.

The plasma is generated by applying a source RF power between about 200 W and about 1500 W, for example 300-350 W, to an inductor coil to generate and sustain a plasma of the processing gases during the etching process. A bias power between about 25 W and about 200 W, for example about 15-20 W, is applied to the substrate support 124. The etching process is performed between about 90 seconds and about 400 seconds, for example, about 350 seconds. Endpoint of the metal layer 320 etching process may be monitored by an optical emission endpoint control.

Generally, the processing chamber pressure is maintained between about 1 milliTorr and about 40 milliTorr, for example, at about 3 milliTorr, about 5 milliTorr, or about 8 milliTorr. The substrate temperature is between about 20 °C and about 100 °C during the etching process. Additionally, the sidewalls 104 of the processing chamber 100 are maintained at a temperature of less than about 70 °C and the dome is maintained at a temperature of less than about 80 °C. The above described metal etching process generally produces a selectivity of metal layer to resist of about 3:1 or greater.

Alternatively, an overetch step may be performed after the etching process to ensure removal of all of the desired material from the substrate. The overetch may use any suitable processing gas for etching the metal layer 320. For example, the overetching gas may comprise one or more, including all, of the oxygen containing gas, the chlorine containing gas, the chlorine free halogen containing gas, and the inert gases described herein.

Alternatively, if an ARC material as described herein is formed on the metal layer, the ARC material may be removed with the metal layer during the metal layer etching process or may be removed by an etching process before etching of the metal layer. An example of a ARC etching process and metal layer etching process is more fully described in United States Patent Application No. 10/803,867, filed on March 18, 2004, and entitled "Multi-Step Process For Etching Photomasks".

The etching process described herein under the conditions disclosed produces a removal rate ratio, *i.e.,* selectivity or etch bias, of metal layer to resist of about 1:1 or greater. A selectivity of metal to resist of about 1:1 or greater has been observed in a substrate 122 processed by the etching process described herein. A selectivity of metal to resist of about 3:1 or greater has been observed in substrate processed by the etching process described herein. The increased selectivity results in the etching processes preserve the critical dimension patterned in the photoresist layer and allows for etched chromium features to have the desired critical dimensions.

The etching processes as described herein were also observed to remove "top" or upper surface resist material independent of "side" within feature resist material, which is consistent with anisotropic etching and improved feature formation. Additionally, processed substrates have produced features with the desired critical dimensions with an almost vertical profile, *i.e.,* an angle of about 90 degrees between the sidewall of the feature and the bottom of the feature compared to prior art result of about 85 degrees to about 88 degrees.

Optionally, a plasma strike may be used to generate the plasma for etching the metal layer 320. A plasma strike may be used to initiate or generate the plasma prior to introducing the processing gas at the compositions and flow rates described herein for the etching process. The plasma strike may use an inert gas or a composition of the processing gases described herein.

The processing conditions and the plasma conditions of the plasma strike process may approximate those of the etching process with the processing gas described herein including processing gas constituents of the processing gas, total flow rates, chamber pressures, source power, and bias power. The plasma strike process may be for about 15 seconds or less, such as between about 3 seconds and about 5 seconds. An example of plasma striking includes establishing the chamber pressure between about 1 milliTorr and about 40 milliTorr, for example, between about 3 milliTorr and about 8 milliTorr, supplying a source power to a coil at a range between about 200 W and about 1500 W, such as about 300-350 W, and/or supplying a bias at a range between about 5 Watt and about 200 W, such as between about 15 W and about 20 W. The source power used to strike the plasma may be less than the power used during etching of the substrate 122.

After etching of the metal layer 320 is completed, the substrate 122 is transferred to a processing chamber 100, and the remaining resist material 330 is usually removed from the substrate 122, such as by an oxygen plasma process, or other resist removal technique known in the art as shown in Figure 3D.

Optionally, an attenuating material may used to form an attenuating phase shift photomasks to increase the precision of the etching pattern formed on the substrate by increasing the resolution of the light passing through the photomask. An attenuating material, such as molybdenum silicide (MoSi) or derivative may be disposed between the opaque metal layer 320 and the optically transparent substrate surface 310 may then be etched. The attenuating material may be deposited on the optically transparent substrate or may be integrated in the optically transparent substrate during manufacturing of the optically transparent substrate. For example, if an attenuating material is disposed on the substrate surface prior to deposition of the metal layer 320, the attenuating material may be formed by depositing and patterning a second photo resist material on the now patterned metal layer 320 to expose the underlying material at step 250. The underlying material of the attenuating material, or the exposed substrate itself if appropriate, may be then be etched with an etching gases suitable for such materials at step 260.

An example of etching the optically transparent material, such as silicon-based material, and attenuating materials of the substrate 122 is more fully described in United States Patent Application No. 10/437,729 filed on May 13, 2003, and entitled "Methods For Etching Photolithographic Reticles", and U.S. Patent No. 6,391,790, filed on May 21, 2002.

The above described processing gas composition and processing regime is believed to provide controllable etching of openings or patterns with desired critical dimensions. The etching of the openings or patterns is generally anisotropic with the use of the processing gas described herein. The anisotropic process removes material deposited on the bottom of the opening at a higher rate than material on the sidewalls of the opening. This results in materials on the sidewalls of the openings being removed at a lower rate than materials on the bottoms of openings. An etch process that etches the sidewalls of the openings at a slower rate will be less likely to overetch the sidewalls allowing for improved preservation of the critical dimensions of the openings being etched, and, thus, reducing etching bias.

The invention is further described by the following examples that are not intended to limit the scope of the claimed invention.

### Examples

A photolithographic reticle including a substrate made of an optically transparent material, such as optical quality quartz, fused silica, molybdenum silicide, molybdenum silicon oxynitride (MoSi_{X}N_{Y}O_{Z}), calcium fluoride, alumina, sapphire, or combinations thereof, with a chromium photomask layer, for example, between about 70 nanometers (nm) and about 100 nm thick disposed thereon, is introduced into a processing chamber for resist deposition. An optional ARC layer of chromium oxynitride, which may comprise up to about 25 percent of the total chromium depth, may be formed.

A resist, such as ZEP, a resist material commercially available from Tokyo-Oka of Japan, or a chemically amplified resist or CAR resist also commercially available from Tokyo-Oka of Japan, is deposited upon the chromium oxynitride layer and then patterned using conventional laser or electron beam patterning equipment. The resist deposited on the substrate is between about 200 nm and about 600 nm thick, for example, between about 300 nm and about 400 nm thick, but may be of any thickness desired.

According to some embodiments methods and apparatuses for etching a metal layer disposed on a substrate, such as a photolithographic reticle, are provided. As an example, a method is provided for processing a substrate including positioning a substrate having a metal photomask layer disposed on a optically transparent material in a processing chamber, introducing a processing gas processing gas comprising an oxygen containing gas, a chlorine containing gas, at least one of trifluoromethane (CHF₃), sulfur hexafluoride (SF₆), hexafluoroethane (C₂F₆) or ammonia (NH₃) and optionally a chlorine-free halogen containing gas and/or an inert gas, into the processing chamber, generating a plasma of the processing gas in the processing chamber, and etching exposed portions of the metal layer disposed on the substrate.

While the foregoing is directed to the exemplary aspects of the invention, other and further aspects of the invention may be devised without departing from the basic scope thereof, and the scope thereof is determined by the claims that follow.

## Claims

1. A method for processing a photolithographic reticle, comprising:
positioning the reticle (122) on a support member (124) in a processing chamber (100), wherein the reticle comprises a metal photomask layer (320) formed on an optically transparent substrate (310) and a patterned resist material (330) deposited on the metal photomask layer;
introducing a processing gas comprising an oxygen containing gas, a chlorine containing gas, and at least one of trifluoromethane (CHF₃), sulfur hexaflouride (SF₆), hexafluoroethane (C₂F₆) or ammonia (NH₃);
delivering power to the processing chamber (100) to generate a plasma formed from the processing gas; and
etching exposed portions of the metal photomask layer (320) using the plasma.

2. The method of claim 1, the step of introducing the processing gas further comprising flowing a chlorine-free halogen containing gas into the processing chamber.

3. The method of claim 2, the step of introducing the processing gas further comprising flowing at least one of hydrogen bromide or hydrogen iodide into the processing chamber.

4. The method of any of claims 1 to 3, the step of introducing the processing gas further comprising flowing at least one of oxygen, carbon monoxide or carbon dioxide into the processing chamber.

5. The method of any of claims 1 to 4, the step of introducing the processing gas further comprising flowing at least one of chlorine, carbon tetrachloride or hydrochloric acid into the processing chamber.

6. The method of any of claims 1 to 5, wherein the metal photomask layer (320) comprises chromium, chromium oxynitride, or combinations thereof.

7. The method of any of claims 1 to 6, wherein the metal photomask layer further comprises an anti-reflective coating of chromium oxynitride.

8. The method of any of claims 1 to 7, wherein the optically transparent substrate (310) comprises a silicon-based material selected from the group of quartz, molybdenum silicide, molybdenum silicon oxynitride, and combinations thereof.

9. The method of any of claims 1 to 8, the step of generating a plasma further comprising applying a source RF power between about 200 Watts and about 1500 Watts to a coil in the processing chamber (100) and applying a bias power between about 5 Watts and about 200 Watts to a reticle support in the processing chamber.

10. The method of any of claims 1 to 8, the step of etching the metal photomask layer further comprising selectively etching the metal photomask layer at a metal photomask layer to resist material ratio between about 1:1 and about 3:1.

11. A method for processing a photolithographic reticle, comprising:
positioning the reticle (122) on a support member (124) in a processing chamber (100), wherein the reticle comprises a chromium-based photomask layer formed on an optically transparent silicon-based material and a patterned resist material (330) deposited on the chromium-based photomask layer;
introducing a processing gas comprising chlorine gas, oxygen gas and at least one of trifluoromethane (CHF₃), sulfur hexaflouride (SF₆), hexafluoroethane (C₂F₆) or ammonia (NH₃);
maintaining a chamber pressure between about 3 milliTorr and about 8 milliTorr and the reticle at a temperature between about 20°C and about 150°C during processing;
delivering a source power between about 300 and about 350 Watts to a coil disposed proximate the processing chamber to generate a plasma from the processing gas;
supplying a bias power to the support member (124) between about 15 and about 20 Watts;
etching exposed portions of the chromium-based photomask layer; and
removing the chromium-based photomask layer at a removal rate ratio of chromium-based photomask layer to resist material of about 1:1 or greater.

12. The method of claim 11, the step of introducing the processing gas further comprising flowing hydrogen bromide into the processing chamber.

13. The method of any of claims 11 to 12, wherein the chromium-based photomask layer comprises chromium, chromium oxynitride, or combinations thereof, and the optically transparent silicon-based material comprises quartz, molybdenum silicide, molybdenum silicon oxynitride, or combinations thereof.

14. The method of any of claims 11 to 13, wherein the reticle (122) further comprises an anti-reflective coating of chromium oxynitride.

15. The method of any of claims 1 to 14, the step of introducing a processing gas further comprising flowing argon into the processing chamber (100) at a flow rate of 5-100 sccms.

16. The method of any of claims 1 to 15, the step of introducing a processing gas further comprising flowing argon into the processing chamber at a flow rate of 20-45 sccms.

17. The method of any of claims 1 to 16, wherein the step of introducing a processing gas further comprises flowing at least one of helium, argon, xenon, neon or krypton into the processing chamber.

18. The method of any of claims 11 to 17, wherein the metal photomask layer (320) and the resist material are removed at a removal rate ratio of metal photomask layer to resist material between about 1:1 and about 3:1.

19. The method of any of claims 1 to 18, the step of introducing the processing gas further comprising flowing the at least one of trifluoromethane (CHF₃), sulfur hexaflouride (SF₆), hexafluoroethane (C₂F₆) or ammonia (NH₃) into the processing chamber at a rate of about 1 sccms to 50 sccms.

20. The method of any of claims 1 to 19, the step of introducing the processing gas further comprising flowing the at least one of trifluoromethane (CHF₃), sulfur hexaflouride (SF₆), hexafluoroethane (C₂F₆) or ammonia (NH₃) into the processing chamber (100) at a rate of about 1 sccms to 5 sccms.
